# EUROPEAN PATENT APPLICATION

(11) **EP 1 363 134 A2**
(43) Date of publication of application: **19.11.2003**
(21) Application number: 03252908.3
(22) Date of filing: 09.05.2003
(51) Int. Cl.: G01R 33/09

(54) **A magnetic field detection system**

(30) Priority: 14.05.2002 US 146176
(71) Applicant: Hewlett-Packard Company, Palo Alto, CA 94304 (US)
(72) Inventor: Sharma, Manish, Mountain View, CA 94043 (US); Perner, Frederick, Palo Alto, CA 94306 (US)
(74) Representative: Tollett, Ian

(57) **Abstract**

The invention includes a magnetic field detection sensor. The magnetic field detection sensor includes a first magnetic sensor (200) including a first sense layer (220) and a first reference layer (210). A second magnetic sensor (202) includes a second sense layer (222) and a second reference layer (212). The first magnetic sensor is physically oriented relative to the second magnetic sensor so that external magnetic fields detected by the magnetic field detection sensor cause a relative magnetic orientation of the first sense layer to the first reference layer to be opposite of a relative magnetic orientation of the second sense layer to the second reference layer. A differential amplifier can senses the relative magnetic orientations of the first junction sensor and the second junction sensor.

## Description

The invention relates generally to a magnetic field detection sensor. More particularly, the invention relates to an apparatus, system and method for sensing magnetic fields with at least two magnetic sensors.

Magnetic field detection can be used for sensing information stored on a surface of a magnetic medium, such as, a magnetic disk or tape. The magnetic sensor must be physically located proximate to the magnetic medium to allow detection of the magnetically stored information.

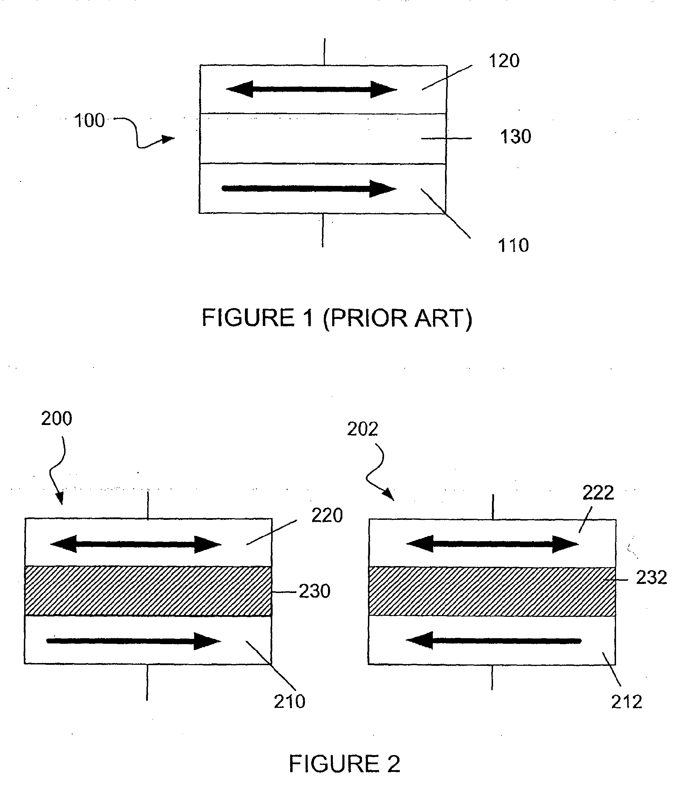

A device that can be used to detect the presence of a magnetic field is a magnetic tunnel junction sensor. Figure 1 shows an embodiment of a magnetic tunnel junction sensor 100. The magnetic tunnel junction sensor 100 includes a pinned layer 110, a sense layer 120 and a insulating layer 130.

The pinned layer 110 has a magnetization orientation that is fixed, and will not rotate in the presence of an applied magnetic field in a range of interest. The sense layer 120 has a magnetization that can be oriented in either of two directions. A first magnetization orientation of the sense layer 120 is in the same direction as the fixed magnetization of the pinned layer 110. A second magnetization orientation of the sense layer 120 is in the opposite direction as the fixed magnetization of the pinned layer 110.

The magnetic orientation of the sense layer 120 is generally aligned in a direction corresponding to a direction of the last external magnetic field that sense layer 120 in the vicinity of the sense layer 120. The external magnetic field must have enough magnetic strength to alter the orientation of the sense layer 120 in order for the magnetic field to be detected.

A resistance across the magnetic tunnel junction sensor 100 will vary in magnitude depending upon the magnetic orientation of the sense layer 120 with respect to the magnetic orientation of the pinned layer 110. Typically, if the sense layer 120 has a magnetic orientation that is in the opposite direction as the pinned layer 110, then the resistance across the magnetic tunnel junction sensor 100 will be large. If the sense layer 120 has a magnetic orientation that is in the same direction as the pinned layer 110, then the resistance across the magnetic tunnel junction sensor 100 will be less. Therefore, the resistance across the magnetic tunnel junction sensor 100 can be used to sense the direction of a magnetic field because the direction of the magnetic field determines the magnetic orientation of the sense layer 120 with respect to the pinned layer 110, and therefore, the resistance across the magnetic sensor 100.

Sensitivity of the magnetic sensor 100 of Figure 1 is limited. The resistive state of the magnetic sensor is determined by comparing a sensed resistance with a predetermined resistive threshold value, and making a magnetic sensor state determination based upon the comparison. That is, if the sensed resistance is less than the predetermined threshold value, then the state of the magnetic sensor is a first state. If the sensed resistance is greater than the predetermined threshold value, then the state of the magnetic sensor is the second state.

It is desirable to have an apparatus and method for sensing magnetic fields that provides improved sensitivity, is non-volatile and dissipates low power.

The invention includes an apparatus and system of sensing magnetic fields that provides improved sensitivity, is non-volatile and dissipates low power.

A first embodiment of the invention includes magnetic field detection sensor. The magnetic field detection sensor includes a first magnetic sensor including a first sense layer and a first reference layer. The magnetic field detection sensor further includes a second magnetic sensor that includes a second sense layer and a second reference layer. The first magnetic sensor is physically oriented relative to the second magnetic sensor so that external magnetic fields detected by the magnetic field detection sensor cause a relative magnetic orientation of the first sense layer to the first reference layer to be opposite of a relative magnetic orientation of the second sense layer to the second reference layer.

Other aspects and advantages of the present invention will become apparent from the following detailed description, taken in conjunction with the accompanying drawings, illustrating by way of example a number of preferred embodiments of the invention.
Figure 1 shows a magnetic tunnel junction sensor.
Figure 2 shows an embodiment of the invention.
Figure 3 shows another embodiment of the invention.
Figure 4 shows another embodiment of the invention.
Figure 5 shows a pair of magnetic tunnel junction sensors and a differential amplifier according to an embodiment of the invention.
Figure 6 shows a pair of magnetic tunnel junction sensors and a differential amplifier according to another embodiment of the invention.
Figures 7 shows a pair of magnetic tunnel junction sensors according to an embodiment of the invention.
Figure 8 shows a pair of magnetic tunnel junction sensors according to another embodiment of the invention.
Figure 9 shows a pair of magnetic tunnel junction sensors according to another embodiment of the invention.
Figure 10 shows an array of magnetic sensors according to an embodiment of the invention.
Figure 11 shows a disk drive that includes a read head that includes a magnetic sensor according to an embodiment of the invention.

As shown in the drawings for purposes of illustration, the invention is embodied in an apparatus and system of sensing magnetic fields that provides improved sensitivity, is non-volatile and dissipates low power.

Figure 2 shows an embodiment of the invention. This embodiment includes two magnetic tunnel junction sensors 200, 202 that are physically located adjacent to each other. A first reference (pinned) layer 210 of a first tunnel junction sensor 200 includes a preset magnetic orientation that is opposite of preset magnetic orientation of a second reference (pinned) layer 212 of a second tunnel junction sensor 202.

The first tunnel junction sensor 200 further includes a first sense layer 220, and a first insulating tunnel barrier 230 that separates the first reference layer 210 and the first sense layer 220. The second junction sensor 202 further includes a second sense layer 222, and a first insulating tunnel barrier 232 that separates the second reference layer 212 and the second sense layer 222.

The reference layers 210, 212 and the sense layers 220, 222 can be made of a ferromagnetic material.

If the magnetization of the sense layer and a reference layer of a magnetic tunnel junction sensor are in the same direction, the orientation of the magnetic tunnel junction sensor can be referred to as being "parallel." If the magnetization of the sense layer and the reference layer of the magnetic tunnel junction sensor are in opposite directions, the orientation of the magnetic tunnel junction sensor can be referred to as being "anti-parallel." The two orientations, parallel and anti-parallel, can correspond to magnetic sensor states of low or high resistance.

The insulating tunnel barriers 230, 232 allow quantum mechanical tunneling to occur between the reference layers 210, 212 and the sense layers 220, 222. The tunneling is electron spin dependent, causing the resistance of the magnetic tunnel junction sensors 200, 202 to be a function of the relative orientations of the magnetization directions of the reference layers 210, 212 and the sense layers 220, 222. The presence of a magnetic field can be detected by establishing the magnetization orientations of the reference layers 210, 212 and the sense layers 220, 222.

The resistance of each of the magnetic tunnel junction sensors 200, 202 is a first value (R) if the magnetization orientation of the magnetic tunnel junction sensor 200, 202 is parallel and a second value (R+delta) if the magnetization orientation is anti-parallel. The invention, however, is not limited to the magnetization orientation of the two layers, or to just two layers.

The insulating tunnel barriers 230, 232 can be made of aluminum oxide, silicon dioxide, tantalum oxide, silicon nitride, aluminum nitride, or magnesium oxide. However, other dielectrics and certain semiconductor materials may also be used for the insulating tunnel barriers 230, 232. The thickness of the insulating tunnel barriers 230, 232 may range from about 0.5 nanometers to about three nanometers. However, the invention is not limited to this range.

The sense layers 220, 222 may be made of a ferromagnetic material. The reference layers 210, 212, as will be described layer, can be implemented as a synthetic ferrimagnet (SF), also referred to as an artificial antiferromagnet.

The first sense layer 220 of the first tunnel junction sensor 200 will generally align in a direction that correspond with a direction of an externally applied magnetic field. The second sense layer 222 of the second tunnel junction sensor 202 will also generally align in a direction that correspond with a direction of an externally applied magnetic field. Due to the placement and physical orientation of the first tunnel junction sensor 200 and the second tunnel junction sensor 202, the first sense layer 220 and the second sense layer 222 will generally include magnetic orientations that are in the same direction after being subjected to an external magnetic field.

As previously mentioned, the resistance across the magnetic tunnel junction sensors 200, 202 is directly dependent upon the orientation of magnetization of the sense layers 220, 222 with respect to the orientation of the magnetization of the reference (pinned) layers 210, 212. Also, as previously stated, the magnetic orientation of the first reference layer 210 is in the opposite direction as the magnetic orientation of the second reference layer 212. Therefore, the resistance across the first magnetic tunnel junction sensor 200 and resistance across the second magnetic tunnel junction sensor 202 will generally be very different after the first magnetic tunnel junction sensor 200 the second magnetic tunnel junction sensor 202 are exposed to an external magnetic field. That is, one of the magnetic tunnel junction sensors will include a high resistance (R+delta R) and the other magnetic tunnel junction sensor will include a lower resistance (R).

The first magnetic tunnel junction sensor 200 is physically oriented relative to the second magnetic tunnel junction sensor 202 so that external magnetic fields detected by the magnetic field detection sensors 200, 202 causes a relative magnetic orientation of the first sense layer 220 to the first reference layer 210, to be opposite of a relative magnetic orientation of the second sense layer 222 to the second reference layer 212.

A differential amplifier can be used for sensing the relative magnetic orientations of the first magnetic tunnel junction sensor 200 and the second magnetic tunnel junction sensor 202. That is, the differential amplifier detects the resistive difference between the first magnetic tunnel junction sensor 200 and the second magnetic tunnel junction sensor 202.

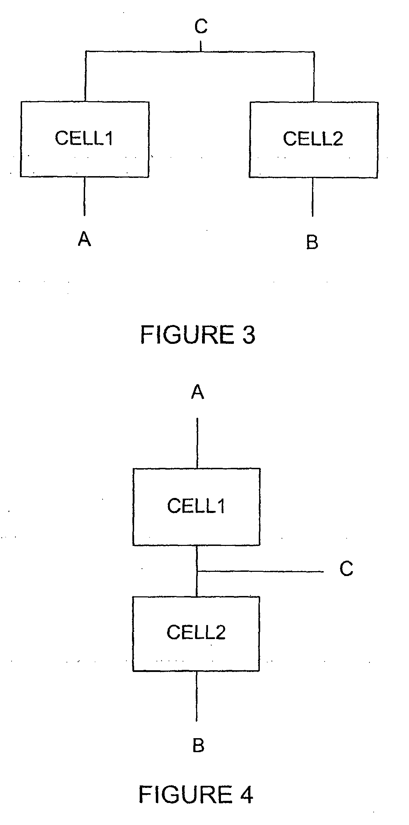

Figure 3 shows another embodiment of the invention. In Figure 3, each magnetic tunnel junction sensor is designated as a cell (cell 1 and cell2). The cells can be physically oriented in a side by side configuration. As will be described later, some embodiments of the invention can be configured according to this side by side configuration. References A, B and C designate points of contact with external electronic circuits.

Figure 4 shows another embodiment of the invention. Again, each magnetic tunnel junction sensor is designated as a cell. The cells (cell1 and cell2) can be physically oriented in an end to end configuration. As will be described later, some embodiments of the invention can be configured according to this end to end configuration. References A, B and C designate points of contact with external electronic circuits.

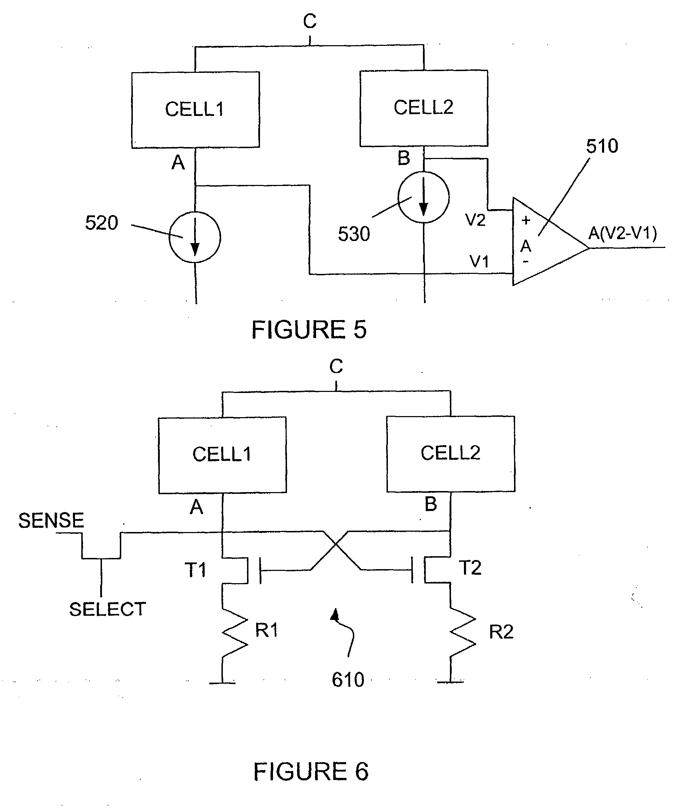

Figure 5 shows a pair of magnetic tunnel junction sensors (cell1 and cell2) and a differential amplifier 510 according to an embodiment of the invention. The differential amplifier 510 senses relative magnetic orientations of the first magnetic sensor (cell1) and the second magnetic sensor (cell2). As previously described, the magnetic orientations of the magnetic sensors (cell1 and cell2) determine the resistance across the magnetic sensors.

A first current source 520 causes current to be conducted through the first magnetic sensor (cell1), generating a first voltage potential V1 that is dependent upon the resistive state of the first magnetic sensor (cell1). A second current source 530 causes current to be conducted through the second magnetic sensor (cell2), generating a second voltage potential V2 that is dependent upon the resistive state of the second magnetic sensor (cell2). The first and second current sources 520, 530 are of substantially equal magnitude.

The magnitudes of the first voltage potential V1 and the second voltage potential V2 are dependent upon the resistance of the first magnetic sensor (cell1) and the second magnetic sensor (cell2). The differential amplifier 510 detects relative degrees of resistance differences between the first magnetic sensor (cell 1) and the second junction sensor (cell2) by generating an output having an amplitude of A(V2-V1) where A is a gain of the differential amplifier 510.

Therefore, the presence of an external magnetic field and the direction of the magnetic field can be determined by the output of the differential amplifier 510. The detection of the external magnetic field will cause the magnetization of the sense layers of the magnetic sensors (cell1, cell2) to align with the external magnetic field. Due to the fact that the reference layers of the magnetic sensors (cell1, cell2) have magnetization directions that are fixed in opposite directions, the resistance of the first magnetic sensor (cell1) will be greater or less than the resistance of the second magnetic sensor (cell2) depending upon the direction of the external magnetic field. The output of the differential amplifier will, therefore, provide an indication of the presence, and the direction of the external magnetic field.

Figure 6 shows a pair of magnetic tunnel junction sensors (cell1 and cell2) and a differential amplifier 610 according to another embodiment of the invention. The differential amplifier 610 senses the relative magnetic orientations of the first magnetic sensor (cell1) and the second magnetic sensor (cell2). The differential amplifier 610 includes a cross-coupled differential pair of transistors T1, T2 that detect whether the first magnetic sensor or the second magnetic sensor has a greater resistance.

The state of the magnetic sensors is detected by a applying a positive voltage potential at contact point C (for example, through a clock SCLOCK). The state is then sensed at VSENSE through a select line (SELECT).

If the first magnetic sensor (cell1) has a greater resistance than the second magnetic sensor (cell2), then the voltage potential at contact point A will be lower than the voltage potential at contact point B. Therefore, transistor T1 will be turned on more than that transistor T1. Current flowing through resistor R1, transistor T1 and the first magnetic sensor (cell1) will be greater than the current flowing though resistor R2, transistor T2 and the second magnetic sensor (cell2). Therefore, transistor T2 will be forced to turn completely off, and transistor T1 will saturate. The result will be that VSENSE will be a low voltage potential.

If the second magnetic sensor (cell2) has a greater resistance than the first magnetic sensor (cell1), then the voltage potential at contact point B will be lower than the voltage potential at contact point A. Therefore, transistor T2 will be turned on more than that transistor T1. Current flowing through resistor R2, transistor T2 and the second magnetic sensor (cell2) will be greater than the current flowing though resistor R1, transistor T1 and the first magnetic sensor (cell1). Therefore, transistor T1 will be forced to turn completely off, and transistor T2 will saturate. The result will be that VSENSE will be a high voltage potential.

The presence of an external magnetic field and the direction of the magnetic field can be determined by the output of the differential amplifier 610. The detection of the external magnetic field will cause the magnetization of the sense layers of the magnetic sensors (cell1, cell2) to align with the external magnetic field. Due to the fact that the reference layers of the magnetic sensors (cell1, cell2) have magnetization directions that are fixed in opposite directions, the resistance of the first magnetic sensor (cell1) will be greater or less than the resistance of the second magnetic sensor (cell2) depending upon the direction of the external magnetic field. The output of the differential amplifier will, therefore, provide an indication of the direction of the external magnetic field.

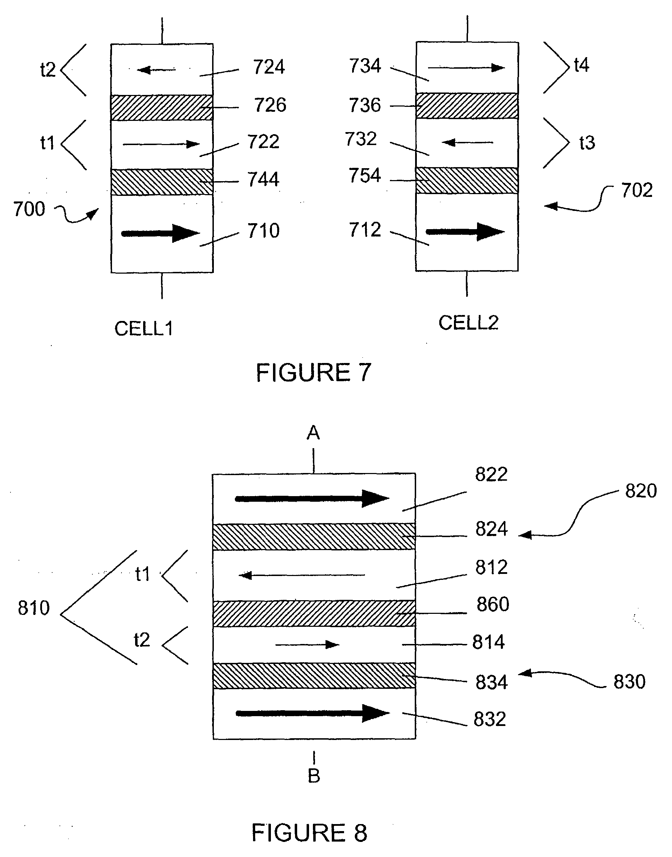

Figures 7 shows a pair of magnetic tunnel junction sensors 700, 702 according to an embodiment of the invention. Each of the magnetic tunnel junction sensors 700, 702 of this embodiment include a reference (pinned) layer 710, 712. The fixed magnetic orientations of the reference layers 710, 712 are in the same direction. This magnetic orientation can be desirable because the reference layer 710, 712 may be easier to fabricate having fixed magnetic orientations that are in the same direction.

The magnetic tunnel junction sensors 700, 702 also include insulating tunnel barriers 744, 754.

Each of the magnetic tunnel junction sensors 700, 702 of this embodiment include synthetic ferromagnetic structure sense layers. That is, the first magnetic tunnel junction sensor 700 includes a first ferromagnetic structure sense layer that includes a first ferromagnetic layer 722 and a second ferromagnetic layer 724. The first ferromagnetic layer 722 and the second ferromagnetic layer 724 are separated by a non-magnetic spacer layer 726. The second magnetic tunnel junction sensor 702 includes a second ferromagnetic structure sense layer that includes a first ferromagnetic layer 732 and a second ferromagnetic layer 734. The first ferromagnetic layer 732 and the second ferromagnetic layer 734 are separated by a non-magnetic spacer layer 736.

The ferromagnetic layers 722, 724, 732, 734 can be made of a material such as CoFe, NiFe or Co. The spacer layers 726, 736 can be formed from magnetically non-conductive materials such as Ru, Re, Rh or Cu.

There is a strong interlayer exchange coupling between the first ferromagnetic layer 722 and the second ferromagnetic layer 724 of the first magnetic sensor 700. There is a strong interlayer exchange coupling between the first ferromagnetic layer 732 and the second ferromagnetic layer 734 of the second magnetic sensor 702. The magnitude of this coupling and its sign (that is, whether the coupling is positive or negative) is a function of the spacer layers 726, 736 thickness and material, and the ferromagnetic layers 722, 724, 732, 734 thickness and materials. The coupling is negative if the magnetization direction of the first ferromagnetic layer is anti-parallel to the magnetization direction of the second ferromagnetic layer. The coupling is positive if the magnetization direction of the first ferromagnetic layer is parallel to the magnetization direction of the second ferromagnetic layer.

The coercivities of the first ferromagnetic layers 722, 732 may be slightly different than the coercivities of the second ferromagnetic layers 724, 734. For example, the coercivities of the first ferromagnetic layers 722, 732 can be approximately 10 Oe, and the coercivities of the second ferromagnetic layers 724, 734 can be approximately 50 Oe. Generally, the coercivity of the reference layers 710, 712 are higher than the ferromagnetic layers 722, 724, 732, 734.

Since the magnetization of the first ferromagnetic layers 722, 732 are oriented in the opposite direction as the second ferromagnetic layers 724, 734, their moments tend to cancel each other.

The thickness of the spacer layers 726, 736 may be between about .2nm and 2 nm.

Each of the ferromagnetic layers 722, 724, 732, 734 include a magnetization vectors having a magnetic intensity. Generally, the magnetic intensity of each of the ferromagnetic layers 722, 724, 732, 734 is dependent upon a thickness of the ferromagnetic layers 722, 724, 732, 734.

A vector depicted within the first ferromagnetic layer 722 of the first magnetic tunnel junction sensor 700 is longer than a vector depicted within the second ferromagnetic layer 724 of the first magnetic tunnel junction sensor 700. The lengths of the vectors represent the intensity of the magnetization of the first ferromagnetic layer 722 and the intensity of the magnetization of the second ferromagnetic layer 724. As depicted, the vector representing the magnetization intensity of the first ferromagnetic layer 722 is greater than the vector representing the second ferromagnetic layer 724.

Generally, the magnetization magnitude is dependent upon the thickness of the ferromagnetic layer. A thickness t1 represents a thickness of the first ferromagnetic layer 722 of the first magnetic tunnel junction sensor 700. A thickness t2 represents a thickness of the second ferromagnetic layer 724 of the first magnetic tunnel junction sensor 700. For the embodiment of Figure 7, the thickness t1 of the first ferromagnetic layer 722 is greater than the thickness of the second ferromagnetic layer 724. Therefore, the magnetization of the first ferromagnetic layer 722 is greater than the magnetization of the second ferromagnetic layer 724. When exposed to an external magnetic field, the magnetization of the first ferromagnetic layer 722 will align with the external magnetic field.

A thickness t3 represents a thickness of the first ferromagnetic layer 732 of the second magnetic tunnel junction sensor 702. A thickness t4 represents a thickness of the second ferromagnetic layer 734 of the second magnetic tunnel junction sensor 702. For the embodiment of Figure 7, the thickness t3 of the first ferromagnetic layer 732 is less than the thickness of the second ferromagnetic layer 734. Therefore, the magnetization of the first ferromagnetic layer 732 is less than the magnetization of the second ferromagnetic layer 734. When exposed to an external magnetic field, the magnetization of the second ferromagnetic layer 734 will align with the external magnetic field.

Examples of potential thickness and material types of the first ferromagnetic layers 722, 732, second ferromagnetic layers 724, 734 and spacer layers 726, 736 are as follows.

| | Example 1 | Example 2 | Example 3 | Thickness (nm) |
|---|---|---|---|---|
| First Ferromagnetic Layer | CoFe | NiFe | Co | 3.0 |
| Spacer Layer | Ru | Ru | Ru | .75 |
| Second Ferromagnetic Layer | CoFe | NiFe | Co | 4.0 |

The insulating tunnel barriers 744, 754 allow quantum mechanical tunneling to occur between the reference layers 710, 712 and the first ferromagnetic layers 722, 732. The tunneling is electron spin dependent, causing the resistance of the magnetic tunnel junction sensors 700, 702 to be a function of the relative orientations of the magnetization directions of the reference layers 710, 712 and the first ferromagnetic layers 722, 732.

The presence of a magnetic field can be detected by establishing the magnetization orientations of the reference layers 710, 712 and the first ferromagnetic layers 722, 732. This can be accomplished, for example, by incorporating the magnetic tunnel junction sensors 700, 702 into embodiments of inventions as shown in Figure 5 and Figure 6. That is, the difference in resistance across the magnetic tunnel junction sensors 700, 702 can be used to detect the presence of an external magnetic field.

Figure 8 shows a pair of magnetic tunnel junction sensors according to another embodiment of the invention. This embodiment includes a common sense layer structure 810 that is shared by the first magnetic sensor 830 and the second magnetic sensor 820. The first magnetic sensor 820 further includes a first insulating tunnel barrier layer 824, and a first reference layer 822. The second magnetic sensor 830 further includes a second insulating tunnel barrier layer 834, and a second reference layer 832.

The preset magnetization of the first reference layer 822 and the second reference layer 832 are oriented in the same direction.

The common sense layer structure 810 includes a synthetic ferromagnetic structure sense layer that includes a first ferromagnetic layer 812 and a second ferromagnetic layer 814. For this embodiment, a thickness of one of the ferromagnetic layers 812, 814 should be greater than a thickness of the other ferromagnetic layer 812, 814. As depicted in Figure 8, the first ferromagnetic layer 812 is thicker than the second ferromagnetic layer 814. Therefore, the intensity of the magnetization of the first ferromagnetic layer 812 is greater than the intensity of the magnetization of the second ferromagnetic layer 814.

The first ferromagnetic layer 812 and a second ferromagnetic layer 814 are separated by a non-magnetic spacer layer 860.

The direction of the magnetization of the first ferromagnetic layer 812 will align with an externally applied magnetic field. The direction of the magnetization of the second ferromagnetic layer 814 will be anti-parallel to the externally applied magnetic field.

The first insulating tunnel barrier 824 allow quantum mechanical tunneling to occur between the first reference layer 822 and the first ferromagnetic layer 812. The second insulating tunnel barrier 834 allow quantum mechanical tunneling to occur between the second reference layer 832 and the second ferromagnetic layer 814. The tunneling is electron spin dependent, causing the resistance of the magnetic tunnel junction sensors 820, 830 to be a function of the relative orientations of the magnetization directions of the reference layers 822, 832 and the ferromagnetic layers 812, 814.

The presence of a magnetic field can be detected by establishing the magnetization orientations of the reference layers 822, 832 and the ferromagnetic layers 812, 814. This can be accomplished, for example, by incorporating the magnetic tunnel junction sensors 820, 830 into embodiments of inventions as shown in Figure 5 and Figure 6. That is, the difference in resistance across the magnetic tunnel junction sensors 820, 830 can be used to detect the presence of an external magnetic field.

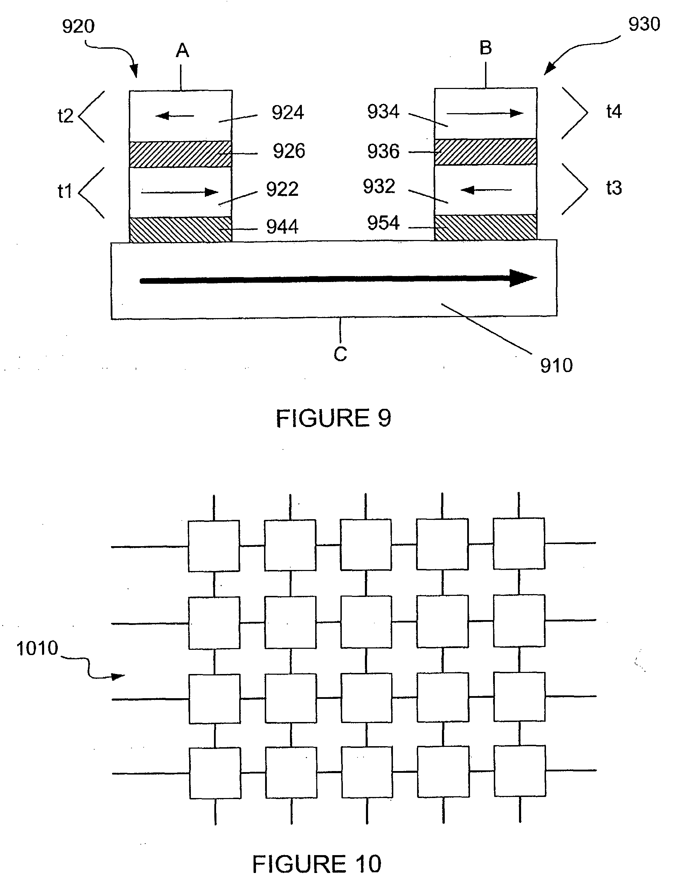

Figure 9 shows a pair of magnetic tunnel junction sensors according to another embodiment of the invention. This embodiment includes a common reference (pinned) layer 910 that is shared by the first magnetic sensor 920 and the second magnetic sensor 930.

This side-by-side synthetic ferri-magnetic structure configuration is similar to the ferri-magnetic structure of Figure 7. However, the common reference layer is shared between the two magnetic tunnel junction sensors 920, 930.

The magnetic tunnel junction sensors 920, 930 include insulating tunnel barriers 944, 954.

Each of the magnetic tunnel junction sensors 920, 930 of this embodiment include synthetic ferromagnetic structure sense layers. That is, the first magnetic tunnel junction sensor 920 includes a first ferromagnetic structure sense layer that includes a first ferromagnetic layer 922 and a second ferromagnetic layer 924. The first ferromagnetic layer 922 and the second ferromagnetic layer 924 are separated by a non-magnetic spacer layer 926. The second magnetic tunnel junction sensor 930 includes a second ferromagnetic structure sense layer that includes a first ferromagnetic layer 932 and a second ferromagnetic layer 934. The first ferromagnetic layer 932 and the second ferromagnetic layer 934 are separated by a non-magnetic spacer layer 936.

Figure 10 shows an array of magnetic sensors 1010 according to an embodiment of the invention. The array of magnetic field detection sensors 1010 includes magnetic field detection sensors according to the embodiments of the invention, located according to a pattern.

The array of magnetic sensors provide for detection and sensing of magnetic fields of varied intensities. That is, detection of an external magnetic field will set the magnetic sensors to varied resistive states. By pre-exposing the array of sensors to a first magnetic field, subsequent magnetic fields will change the state of all or some of the sensors depending upon the intensity and direction of the subsequent magnetic fields.

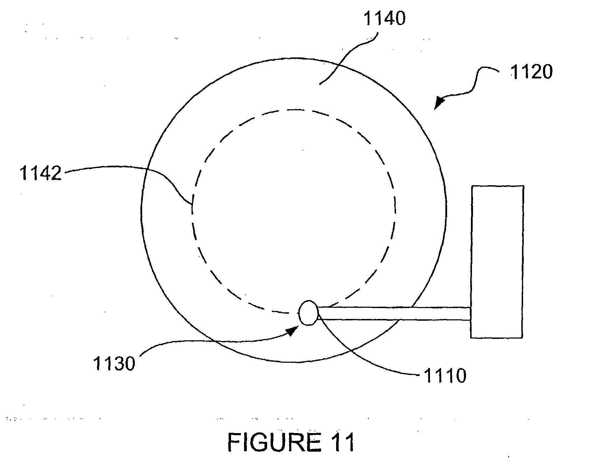

Figure 11 shows a read head 1110 of a magnetic disk drive 1120. The read head 1110 can include a magnetic field sensor 1130 according to an embodiment of the invention. Generally, the magnetic disk drive 1120 includes a magnetic disk 1140 that includes information stored on a surface of the disk 1142. The magnetic field detection sensor 1130 detects the information stored on the surface 1142 of the magnetic disk 1140.

Although specific embodiments of the invention have been described and illustrated, the invention is not to be limited to the specific forms or arrangements of parts so described and illustrated. The invention is limited only by the appended claims.

## Claims

1. A magnetic field detection sensor comprising:
a first magnetic sensor [200] comprising a first sense layer [220] and a first reference layer [210];
a second magnetic sensor [202] comprising a second sense layer [222] and a second reference layer [212];
the first magnetic sensor [200] physically orientated relative to the second magnetic sensor [202] so that external magnetic fields detected by the magnetic field detection sensor cause a relative magnetic orientation of the first sense layer [220] to the first reference layer [210] to be opposite of a relative magnetic orientation of the second sense layer [222] to the second reference layer [212]; and
a differential amplifier for sensing the relative magnetic orientations of the first magnetic sensor [200] and the second magnetic sensor [202].

2. The magnetic field detection sensor of claim 1, wherein the first magnetic sensor [200] and the second magnetic sensor [202] are each a magnetic tunnel junction sensor.

3. The magnetic field detection sensor of claim 1 or 2, wherein magnetic orientations of the first sense layer [220] to the first reference layer [210] determines a resistance of the first magnetic sensor [200].

4. The magnetic field detection sensor of any preceding claim, wherein magnetic orientations of the second sense layer [222] to the second reference layer [212] determines a resistance of the second magnetic sensor [202].

5. The magnetic field detection sensor of any preceding claim, wherein the first reference layer [710] and the second reference layer [712] have fixed magnetic orientations that are in a same direction.

6. The magnetic field detection sensor of any preceding claim, wherein the first sense layer comprises a first synthetic ferromagnetic structure sense layer, and the second sense layer comprises a second synthetic ferromagnetic structure sense layer.

7. The magnetic field detection sensor of claim 6, wherein each synthetic ferromagnetic structure sense layer comprises a first ferromagnetic layer [722, 732] and a second ferromagnetic layer [724, 734] separated by a non-magnetic spacer material; [726, 736], each ferromagnetic layer comprising a thickness and material type that causes the first ferromagnetic layer [722, 732] and the second ferromagnetic layer [724, 734] to be antiferromagnetically coupled.

8. The magnetic field detection sensor of claim 7, wherein a first thickness of the first ferromagnetic layer is different that a second thickness of the second ferromagnetic layer, whereby a first magnetization of the first ferromagnetic layer only partially cancels a second magnetization of the second ferromagnetic layer.

9. The magnetic field detection sensor of claim 7 or 8, wherein each ferromagnetic layer comprises a soft magnetic material.

10. The magnetic field detection sensor of any of claims 1 to 4, wherein the first reference layer [210] and the second reference layer [212] have fixed magnetic orientations that are in opposite directions.
